# EUROPEAN PATENT APPLICATION

(11) **EP 3 065 185 A1**
(43) Date of publication of application: **07.09.2016**
(21) Application number: 14859111.8
(22) Date of filing: 30.10.2014
(51) Int. Cl.: H01L 31/12, G01J 1/02, H01L 33/02

(54) **LIGHT RECEPTION/EMISSION ELEMENT AND SENSOR DEVICE USING SAME**

(30) Priority: 30.10.2013 JP 2013225132
(71) Applicant: Kyocera Corporation, Kyoto-shi, Kyoto 612-8501 (JP)
(72) Inventor: FUJIMOTO, Naoki, Kyoto-shi Kyoto 612-8501 (JP)
(74) Representative: Viering, Jentschura & Partner mbB Patent- und Rechtsanwälte
(86) International application number: PCT/JP2014/078913
(87) International publication number: WO 2015/064697

(57) **Abstract**

A light receiving/emitting element (1) of the invention includes a semiconductor substrate (2) having one conductivity type; a light emitting element (3a) including a plurality of semiconductor layers disposed on an upper surface of the semiconductor substrate (2); a light receiving element (3b) having a reverse conductivity type semiconductor region (32) in the upper surface of the semiconductor substrate (2); and a first electrode pad (33A) disposed on the upper surface of the semiconductor substrate (2), the first electrode pad (33A) being as an electrode of the light receiving element (3b). A region located immediately below the first electrode pad (33A) in the semiconductor substrate (2) having one conductivity type is higher in impurity concentration than other regions in the semiconductor substrate (2) having one conductivity type.

## Description

### Technical Field

The present invention relates to a light receiving/emitting element and a sensor device using the same.

### Background Art

There have heretofore been proposed various sensor devices of a type which detects the characteristics of an object to be irradiated with light by applying light to the to-be-irradiated object from a light emitting element and receiving reflected light relatively to the light incident on the to-be-irradiated object at a light receiving element. Such sensor devices have been utilized for wide range of application fields, including, for example, photo interrupters, photo couplers, remote control units, IrDA (Infrared Data Association) communication devices, an optical fiber communications apparatus, and original size sensors.

There is a disclosure indicating, as such a sensor device, a light receiving/emitting element constructed of a silicon-made semiconductor substrate doped on one side with impurities, on which a superficial p-n junction region responsible for light reception and a deep p-n junction region responsible for light emission are disposed adjacent to each other. In this construction, a p-side electrode and an n-side electrode of the p-n junction region responsible for light reception are disposed on the surface of the semiconductor substrate (refer to Japanese Unexamined Patent Publication JP-A 8-46236 (1996), for example).

However, in the case of integrally forming a light receiving element and a light emitting element on one silicon substrate, upon driving of the light emitting element, leakage current (so-called noise current) may flow from the light emitting element into the light receiving element through the silicon substrate. The leakage current finds its way into an output current from the light receiving element (output current corresponding to the intensity of received light) as an error component (noise). Due to the occurrence of such a noise current, the conventional light receiving/emitting element may suffer from deterioration in the reflected-light detection accuracy of the light receiving element.

The invention has been devised in view of the problems as discussed supra, and accordingly an object of the invention is to provide a light receiving/emitting element having high sensing performance capability, and a sensor device using the same.

### Summary of Invention

According to one embodiment of the invention, a light receiving/emitting element includes: a semiconductor substrate having one conductivity type; a light emitting element comprising a plurality of semiconductor layers disposed on an upper surface of the semiconductor substrate; a light receiving element having a reverse conductivity type semiconductor region in the upper surface of the semiconductor substrate; and a first electrode pad disposed on the upper surface of the semiconductor substrate, the first electrode pad being as an electrode of the light receiving element, a region located immediately below the first electrode pad in the semiconductor substrate having one conductivity type being higher in impurity concentration than other regions in the semiconductor substrate having one conductivity type.

According to one embodiment of the invention, a sensor device includes the light receiving/emitting element mentioned above, the light emitting element applying light to a to-be-irradiated object, the light receiving element outputting an output current corresponding to reflected light from the to-be-irradiated object, the sensor device being configured to detect at least one of positional information, distance information, and concentration information on the to-be-irradiated object based on the output current.

According to the invention, the light receiving/emitting element comprises a semiconductor substrate having one conductivity type, a light emitting element comprising a plurality of semiconductor layers disposed on an upper surface of the semiconductor substrate, a light receiving element having a reverse conductivity type semiconductor region in the upper surface of the semiconductor substrate, and a first electrode pad disposed on the upper surface of the semiconductor substrate, the first electrode pad being as an electrode of the light receiving element, a region located immediately below the first electrode pad in the semiconductor substrate having one conductivity type being higher in impurity concentration than other regions in the semiconductor substrate having one conductivity type. Thus, there are provided a light receiving/emitting element and a sensor device that exhibit high light detection accuracy.

### Brief Description of Drawings

FIG. 1(a) is a plan view showing one embodiment of a light receiving/emitting element pursuant to the invention, and FIG. 1(b) is a schematic sectional view of the light receiving/emitting element taken along the line 1I-1I shown in FIG. 1(a);
FIG. 2(a) is a sectional view of a light emitting element constituting the light receiving/emitting element shown in FIG. 1, and FIG. 2(b) is a sectional view of a light receiving element constituting the light receiving/emitting element shown in FIG. 1;
FIG. 3 is a sectional view of an electrode of the light receiving element constituting the light receiving/emitting element shown in FIG. 1;
FIG. 4 is a schematic sectional view showing one embodiment of a sensor device incorporating the light receiving/emitting element shown in FIG. 1;
FIG. 5(a) is a plan view showing a modified example in the embodiment of the light receiving/emitting element pursuant to the invention, and FIG. 5(b) is a schematic sectional view of the modified example taken along the line 2I-2I shown in FIG. 5(a); and
FIG. 6 is a plan view showing a modified example in the embodiment of the light receiving/emitting element pursuant to the invention different from the modified example shown in FIG. 5.

### Description of Embodiments

Hereinafter, embodiments of a light receiving/emitting element and a sensor device incorporating the light receiving/emitting element pursuant to the invention will be described with reference to drawings. It is noted that the following examples are considered as illustrative only of the embodiments of the invention, and are not intended to limit the scope of the invention.

### (Light receiving/emitting element)

A light receiving/emitting element 1 according to the present embodiment is incorporated in an image forming apparatus such as a copying machine or a printer to serve as a sensor device for detecting information, such for example as positional information, distance information, or concentration information, on a to-be irradiated object such as a toner or media.

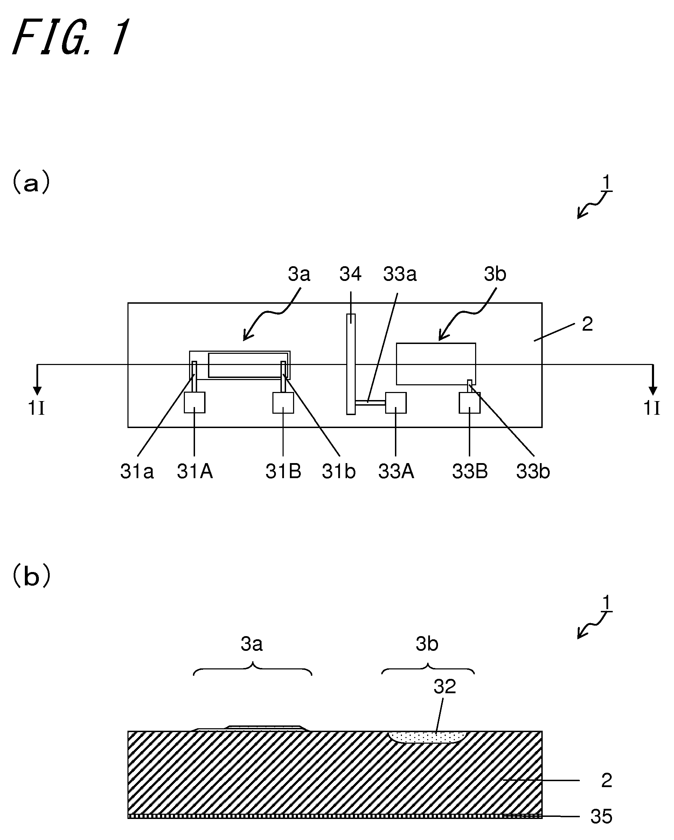

As shown in FIGS. 1(a) and 1(b), the light receiving/emitting element 1 comprises: a semiconductor substrate 2 having one conductivity type; a light emitting element 3a comprising a plurality of semiconductor layers disposed on an upper surface of the semiconductor substrate 2; a light receiving element 3b having a reverse conductivity type semiconductor region 32 in the upper surface of the semiconductor substrate 2, the reverse conductivity type semiconductor region 32 being doped with impurities of reverse conductivity type; and a first electrode pad 33A disposed on the upper surface of the semiconductor substrate 2. The light receiving/emitting element 1 according to the present embodiment is designed to have a single light emitting element 3a and a single light receiving element 3b. In the alternative, the light receiving/emitting element 1 may be designed to have a plurality of light emitting elements 3a and a plurality of light receiving elements 3b.

The semiconductor substrate 2 is made of a semiconductor material having one conductivity type. That is, the semiconductor substrate 2 made of a semiconductor material is doped with impurities so as to become a oneconductivity type semiconductor substrate. Examples of the semiconductor material used to form the semiconductor substrate 2 include silicon (Si). Examples of doping impurities to be added to the semiconductor substrate 2 include phosphorus (P), nitrogen (N), arsenic (As), antimony (Sb), and bismuth (Bi). However, the impurities are not limited to them. For example, the doping concentration of the impurities is adjusted to fall in the range of 1 × 10¹⁴ to 1 × 10¹⁸ atoms/cm³.

While the semiconductor substrate 2 may be of either n type or p type, in the present embodiment, the semiconductor substrate 2 is of n type. That is, in the present embodiment, one conductivity type is defined as n type, and the other conductivity type is defined as p type.

The light emitting element 3a is disposed on the upper surface of the semiconductor substrate 2. The light receiving element 3b is disposed in the vicinity of the light emitting element 3a. The light emitting element 3a serves as a source of light which is applied to a to-be-irradiated object. Light emitted from the light emitting element 3a is reflected from the to-be-irradiated object, and then enters the light receiving element 3b. The light receiving element 3b serves as a light detection section for detecting incidence of light.

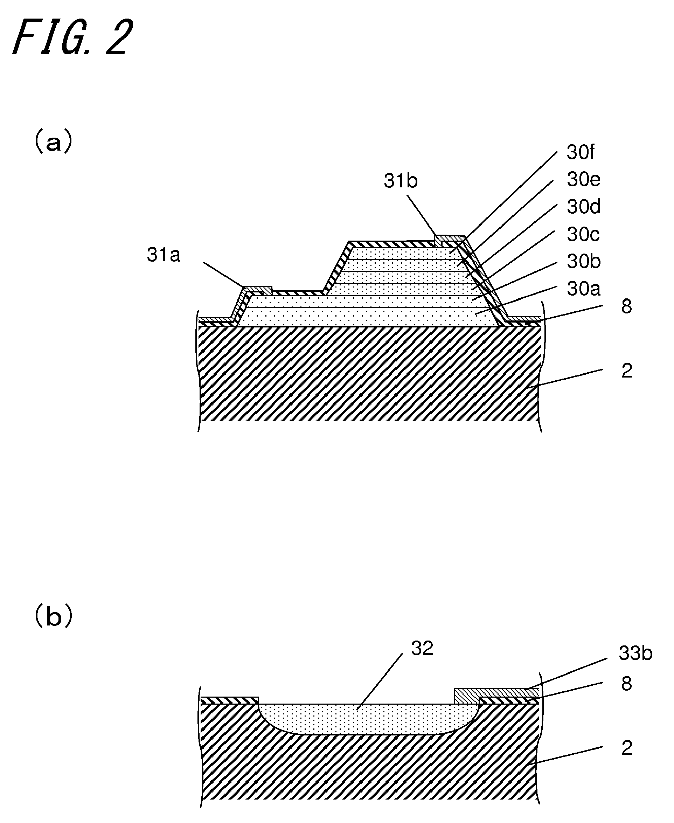

As shown in FIG. 2(a), the light emitting element 3a is constructed by laminating a plurality of semiconductor layers on the upper surface of the semiconductor substrate 2. The following describes the structure of the light emitting element 3a of the present embodiment.

Firstly, on the upper surface of the semiconductor substrate 2, a buffer layer 30a is formed to alleviate the difference in lattice constant between the semiconductor substrate 2 and a semiconductor layer disposed on the upper surface of the semiconductor substrate 2 (in this embodiment, an n-type contact layer 30b which will hereafter be described). The buffer layer 30a makes it possible to reduce lattice defects, such as lattice strain, which occur between the semiconductor substrate 2 and a semiconductor layer constituting the light emitting element 3a, and thereby reduce lattice defects or crystal defects in the entire semiconductor layer constituting the light emitting element 3a formed on the upper surface of the semiconductor substrate 2.

The buffer layer 30a of the present embodiment is made of gallium arsenide (GaAs) free from impurities, for example. Moreover, the thickness of the buffer layer 30a falls in the range of about 2 m to 3 µm, for example. In a case where the difference in lattice constant between the semiconductor substrate 2 and the semiconductor layer constituting the light emitting element 3a disposed on the upper surface of the semiconductor substrate 2 is not large, the buffer layer 30a does not necessarily have to be formed.

An n-type contact layer 30b is formed on an upper surface of the buffer layer 30a. For example, the n-type contact layer 30b is made of gallium arsenide (GaAs) doped with n-type impurities such as silicon (Si) or selenium (Se). For example, the doping concentration of the impurities is set to fall in the range of about 1 × 10¹⁶ to 1 × 10²⁰ atoms/cm³. Moreover, the thickness of the n-type contact layer 30b is set to fall in the range of about 0.8 to 1 µm, for example.

In the present embodiment, as the n-type impurities, silicon (Si) is doped at a doping concentration in the range of 1 × 10¹⁸ to 2 × 10¹⁸ atoms/cm³. Part of an upper surface of the n-type contact layer 30b is left exposed, and, this exposed part is electrically connected to a second electrode pad 31A through a second electrode 31a. The second electrode 31a is an n-type electrode of the light emitting element 3a. In the present embodiment, the second electrode pad 31A is, although it is not represented graphically, electrically connected to an external power supply by wire bonding using a gold (Au) wire. As the electrical connection between the second electrode pad 31A and the external power supply, a wire such as an aluminum (Al) wire or a copper (Cu) wire can be selected instead of a gold (Au) wire.

Moreover, while wire bonding is adopted for the connection between the second electrode pad 31A and the external power supply in the present embodiment, instead of the wire bonding, electrical wiring may be joined to the second electrode pad 31A via solder or the like. In another alternative, a gold stud bump may be formed on an upper surface of the second electrode pad 31A, and electrical wiring may be joined to the gold (Au) stud bump via solder or the like. The n-type contact layer 30b functions to lower the resistance of contact with the second electrode 31a connected to the n-type contact layer 30b.

The second electrode 31a and the second electrode pad 31A are made of, for example, an alloy of gold (Au) and antimony (Sb), an alloy of gold (Au) and germanium (Ge), or an Ni-based alloy. Moreover, the thickness of each of the second electrode 31a and the second electrode pad 31A is set to fall in the range of about 0.5 to 5 µm, for example. The second electrode 31a and the second electrode pad 31A of the present embodiment are made of the gold (Au)-antimony (Sb) alloy. The second electrode 31a and the second electrode pad 31A are disposed on an insulating layer 8 formed over the upper surface of the semiconductor substrate 2 while covering the upper surface of the n-type contact layer 30b, and are thus electrically insulated from the semiconductor substrate 2 and semiconductor layers other than the n-type contact layer 30b.

For example, the insulating layer 8 is formed of an inorganic insulating film such as a silicon nitride (SiNx) film or a silicon oxide (SiO₂) film, or an organic insulating film such as a polyimide film. The thickness of the insulating layer 8 is set to fall in the range of about 0.1 to 1 µm.

An n-type clad layer 30c is formed on the upper surface of the n-type contact layer 30b. The n-type clad layer 30c functions to confine holes in an active layer 30d which will hereafter be described. For example, the n-type clad layer 30c is made of aluminum gallium arsenide (AlGaAs) doped with n-type impurities such as silicon (Si) or selenium (Se). For example, the doping concentration of the n-type impurities is set to fall in the range of about 1 × 10¹⁶ to 1 × 10²⁰ atoms/cm³. The thickness of the n-type clad layer 30c is set to fall in the range of about 0.2 to 0.5 µm, for example. The n-type contact layer 30c of the present embodiment is doped with, as the n-type impurities, silicon (Si) at a doping concentration in the range of 1 × 10¹⁷ to 5 × 10¹⁷ atoms/cm³.

An active layer 30d is formed on an upper surface of the n-type clad layer 30c. The active layer 30d serves as a light emitting section which emits light under concentration and recombination of carriers such as electrons and holes. The active layer 30d is made of aluminum gallium arsenide (AlGaAs) free from impurities, for example. Moreover, the thickness of the active layer 30d is set to fall in the range of about 0.1 to 0.5 µm, for example. While the active layer 30d of the present embodiment is an impurity-free layer, the active layer 30d may be of either a p-type active layer containing p-type impurities or an n-type active layer containing n-type impurities, and a point of importance is that the active layer is smaller in band gap than the n-type clad layer 30c and a p-type clad layer 30e which will hereafter be described.

A p-type clad layer 30e is formed on an upper surface of the active layer 30d. The p-type clad layer 30e functions to confine electrons in the active layer 30d. For example, the p-type clad layer 30e is made of aluminum gallium arsenide (AlGaAs) doped with p-type impurities such as zinc (Zn), magnesium (Mg), or carbon (C). For example, the doping concentration of the p-type impurities is set to fall in the range of about 1 × 10¹⁶ to 1 × 10²⁰ atoms/cm³. The thickness of the p-type clad layer 30e is set to fall in the range of about 0.2 to 0.5 µm, for example. The p-type clad layer 30e of the present embodiment is doped with, as the p-type impurities, magnesium (Mg) at a doping concentration in the range of 1 × 10¹⁹ to 5 × 10¹⁹ atoms/cm³.

A p-type contact layer 30f is formed on an upper surface of the p-type clad layer 30e. For example, the p-type contact layer 30f is made of aluminum gallium arsenide (AlGaAs) doped with p-type impurities such as zinc (Zn), magnesium (Mg), or carbon (C). For example, the doping concentration of the p-type impurities is set to fall in the range of about 1 × 10¹⁶ to 1 × 10²⁰ atoms/cm³. The thickness of the p-type clad layer 30e is set to fall in the range of about 0.2 to 0.5 µm, for example.

The p-type contact layer 30f is electrically connected to a third electrode pad 31B through a third electrode 31b. The third electrode 31b is a p-type electrode of the light emitting element 3a. Like the second electrode pad 31A, the third electrode pad 31B is electrically connected to an external power supply by wire bonding. The method for connecting or joining the third electrode pad 31B may be varied similarly to the case with the second electrode pad 31A. The p-type contact layer 30f functions to lower the resistance of contact with the third electrode 31b connected to the p-type contact layer 30f.

An upper surface of the p-type contact layer 30f may be formed with a cap layer which functions to protect the p-type contact layer 30f from oxidation. For example, the cap layer is made of gallium arsenide (GaAs) free from impurities. Moreover, the thickness of the cap layer is set to fall in the range of about 0.01 to 0.03 µm, for example.

For example, the third electrode 31b and the third electrode pad 31B are made of gold (Au) or aluminum (Al) in combination with nickel (Ni), chromium (Cr), or titanium (Ti) serving as an adherent layer, such as an alloy of AuNi, AuCr, AuTi, or AlCr. The thickness of each of the third electrode 31b and the third electrode pad 31B is set to fall in the range of about 0.5 to 5 µm, for example. The third electrode 31b and the third electrode pad 31B are disposed on an insulating layer 8 formed over the upper surface of the semiconductor substrate 2 while covering the upper surface of the p-type contact layer 30f, and are thus electrically insulated from the semiconductor substrate 2 and semiconductor layers other than the p-type contact layer 30f.

In the thereby constituted light emitting element 3a, upon application of a bias between the second electrode pad 31A and the third electrode pad 31B, the active layer 30d gives forth light. Thus, the light emitting element 3a serves as a light source.

As shown in FIG. 2(b), the light receiving element 3b is constituted by providing the reverse conductivity type semiconductor region 32 (in the light receiving element 3b of the present embodiment, the p-type semiconductor region 32) at the upper surface of the one conductivity type semiconductor substrate 2 so as to form a p-n junction in conjunction with the semiconductor substrate 2. The p-type semiconductor region 32 is formed by diffusing p-type impurities into the semiconductor substrate 2 at high concentration. Examples of the p-type impurities include zinc (Zn), magnesium (Mg), carbon (C), boron (B), indium (In), and selenium (Se). Boron (B) is used as the p-type impurities to form the p-type semiconductor region 32 of the present embodiment. For example, the doping concentration of the p-type impurities is set to fall in the range of 1 × 10¹⁶ to 1 × 10²⁰ atoms/cm³. The thickness of the p-type semiconductor region 32 of the present embodiment is set to fall in the range of about 0.5 to 3 µm, for example.

The p-type semiconductor region 32 is electrically connected to a fourth electrode pad 33B through a fourth electrode 33b, and, the first electrode pad 33A is electrically connected to the semiconductor substrate 2. That is, the fourth electrode pad 33B serves as a p-type electrode of the light receiving element 3b. Moreover, the first electrode pad 33A serves as an n-type electrode of the light receiving element 3b. The fourth electrode 33b and the fourth electrode pad 33B are each disposed on the upper surface of the semiconductor substrate 2, with an insulating layer 8 interposed in between, and are thus electrically insulated from the semiconductor substrate 2.

The first electrode pad 33A is disposed on the upper surface of the semiconductor substrate 2. A region located immediately below the first electrode pad 33A in the semiconductor substrate 2is higher in n-type impurity concentration than other regions in the semiconductor substrate 2. Examples of the n-type impurities include phosphorus (P), nitrogen (N), arsenic (As), antimony (Sb), and bismuth (Bi). Moreover, the doping concentration of the n-type impurities is set to fall in the range of 1 x 10¹⁶ to 1 × 10²⁰ atoms/cm³, for example. Phosphorus (P) is adopted for use as the n-type impurities in the semiconductor substrate 2 of the present embodiment.

In the light receiving/emitting element 1 according to the present embodiment, as described above, the region of the semiconductor substrate 2 located immediately below the first electrode pad 33A is higher in impurity concentration than the other region of the semiconductor substrate 2. In other words, the other regions of the semiconductor substrate 2 are lower in impurity concentration than the region of the semiconductor substrate 2 located immediately below the first electrode pad 33A. That is, since in regions other than the region located immediately below the first electrode pad 33A, the density of carriers is low, electric current is less prone to flow through the other regions. Consequently, this makes it possible to reduce the flow of noise current from the light emitting element 3a into the light receiving element 3b through the interior of the semiconductor substrate 2, and thereby reduce deterioration in the detection accuracy of the light receiving/emitting element 1 caused by noise current from the light emitting element 3a.

The first electrode pad 33A may be ohmic-joined to the semiconductor substrate 2. Consequently, this makes it possible to increase the efficiency of extraction of electrons from the first electrode pad 33A, and thereby improve the detection accuracy of the light receiving element 3b.

A work function of the constituent material of the first electrode pad 33A may be greater than a work function of the constituent material of the semiconductor substrate 2. Consequently, this makes it possible to achieve effective ohmic-joining of the first electrode pad 33A and the semiconductor substrate 2.

On the contrary, the work function of the constituent material of the first electrode pad 33A may be smaller than the work function of the constituent material of the semiconductor substrate 2. In this case, by increasing the impurity concentration of the region located immediately below the first electrode pad 33A, the first electrode pad 33A and the semiconductor substrate 2 can be ohmic-joined to each other.

It is preferable that a region located immediately below the light emitting element 3a corresponds to the other regions which are lower in impurity concentration than the region located immediately below the first electrode pad 33A. Consequently, this makes it possible to reduce noise current from the light emitting element 3a.

It is preferable that the region located immediately below the first electrode pad 33A is clear of the p-type semiconductor region 32. Consequently, this makes it possible to reduce noise current from the light emitting element 3a.

Within the range of the region located immediately below the first electrode pad 33A, a higher impurity concentration may be imparted only to the surface layer area of the semiconductor substrate 2. Consequently, this makes it possible to provide satisfactory electrical connection between the first electrode pad 33A and the semiconductor substrate 2, as well as to reduce the possibility of the flow of noise current from the light emitting element 3a through the interior of the semiconductor substrate 2.

While, in the present embodiment, the region located immediately below the first electrode pad 33A is not limited to a specific region, and a point of importance is that the semiconductor substrate 2 and the first electrode pad 33A can be ohmic-joined to each other, the region may be defined by a region which is greater than or equal to 70% of the area where the semiconductor substrate 2 and the first electrode pad 33A are joined to each other. Moreover, the depthwise thickness of the semiconductor substrate 2 falls in the range of 0.01 to 0.5 µm.

A back electrode 35 of the present embodiment is formed throughout the entire back side of the semiconductor substrate 2.

The fourth electrode 33b, the fourth electrode pad 33B, the first electrode pad 33A, and the back electrode 35 are made of, for example, an alloy of gold (Au) and antimony (Sb), an alloy of gold (Au) and germanium (Ge), or an Ni-based alloy, and their thickness falls in the range of about 0.5 to 5 µm. The fourth electrode 33b, the fourth electrode pad 33B, the first electrode pad 33A, and the back electrode 35 of the present embodiment are made of the gold (Au)-germanium (Ge) alloy.

The first electrode pad 33A is connected to a guard ring electrode 34 through the first electrode 33a, and, the first electrode 33a and the guard ring electrode 34 are disposed on the upper surface of the semiconductor substrate 2. Like the region located immediately below the first electrode pad 33A, a region located immediately below the first electrode 33a and the guard ring electrode 34 in the semiconductor substrate 2 is higher in n-type impurity concentration than the other regions in the semiconductor substrate 2. The guard ring electrode 34 is a strip-shaped electrode formed between the light emitting element 3a and the light receiving element 3b on the upper surface of the semiconductor substrate 2.

Upon application of a bias between the first electrode pad 33A and the back electrode 35 by an external power supply, the first electrode pad 33A, the first electrode 33a, the guard ring electrode 34, and the back electrode 35 constitute a guard ring structure for reduction of leakage current.

In the thereby constituted light receiving element 3b, upon incidence of light on the p-type semiconductor region 32, photoelectric current is generated under the photoelectric effect, and, the photoelectric current is taken out via the fourth electrode pad 33B. Thus, the light receiving element 3b serves as a light detection section. Note that application of a reverse bias between the fourth electrode pad 33B and the first electrode pad 33A is desirable from the standpoint of improving the light detection sensitivity of the light receiving element 3b.

The first electrode pad 33A and the guard ring electrode 34 may be formed integrally with each other. That is, the n-type electrode of the light receiving element 3b may include the function of the guard ring electrode 34. Consequently, this makes it possible to design the n-type electrode of the light receiving element 3b to serve as the guard ring electrode 34.

The first electrode pad 33A may be formed so as to surround the light receiving element 3b. Consequently, this makes it possible to reduce the influence of noise current from the light emitting element 3a upon the light receiving element 3b.

The impurities in the region located immediately below the first electrode pad 33A may be the same as at least one of the elements constituting the semiconductor layer in contact with the upper surface of the semiconductor substrate 2. Consequently, this makes it possible to diffuse the impurities into the upper surface of the semiconductor substrate 2 concurrently with the formation of the buffer layer 30a, and thereby omit some steps from the process of manufacture of the light receiving/emitting element 1, with a consequent increase in production efficiency.

The second electrode 31a and the first electrode pad 33A may be made of the same material. Consequently, this makes it possible to form the second electrode pad 31A and the first electrode pad 33A at one time, and thereby omit some steps from the process of manufacture of the light receiving/emitting element 1, with a consequent increase in production efficiency. Note that the second electrode pad 31A and the first electrode pad 33A may be made of the same material.

The first electrode pad 33A may lie closer to the light emitting element 3a than the fourth electrode pad 33B.

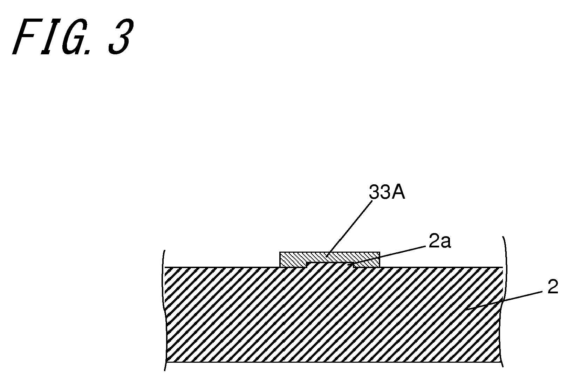

As shown in FIG. 3, in the region of the semiconductor substrate 2 of the present embodiment which is located immediately below the first electrode pad 33A, a projection 2a may be formed so as to protrude toward the first electrode pad 33A. Moreover, the first electrode pad 33A may be configured to cover the projection 2a. Consequently, this makes it possible to enable the first electrode pad 33A to be ohmic-joined also to the lateral side of the projection 2a, and thereby achieve effective reduction of the influence of noise current from the light emitting element 3a.

In the semiconductor substrate 2, a region within the range of the projection 2a may be the only region which is higher in impurity concentration than the other region. Consequently, this makes it possible to reduce the flow of noise current from the light emitting element 3a through the interior of the semiconductor substrate 2.

Moreover, in the region of the semiconductor substrate 2 located immediately below the first electrode 33a and the guard ring electrode 34, a projection 2a may be formed so as to protrude toward the first electrode 33a and the guard ring electrode 34. The first electrode 33a and the guard ring electrode 34 may be configured to cover the projection 2a. Consequently, this makes it possible to achieve effective reduction of the influence of noise current from the light emitting element 3a.

It is advisable that the projection 2a protrudes toward the first electrode pad 33A in a protruding amount of about 1 µm, and the protruding area of the projection 2a is equal to 70% to 90% of each of the area of the first electrode pad 33A, the area of the first electrode 33a, and the area of the guard ring electrode 34 as seen in a plan view. In this construction, the first electrode pad 33A, the first electrode 33a, and the guard ring electrode 34 are formed so as to cover the projection, wherefore the semiconductor substrate 2 and these electrode components are joined to each other in a three-dimensional manner, thus increasing their joining strength.

(Method of manufacturing Light receiving/emitting element)

The following describes examples of the method of manufacturing the light receiving/emitting element 1.

Firstly, the n-type semiconductor substrate 2 is prepared. The semiconductor substrate 2 is made of an n-type semiconductor material. The concentration of n-type impurities is not limited to any particular value. In the present embodiment, use is made of an n-type silicon (Si) substrate constructed of a silicon (Si) substrate containing phosphorus (P) as n-type impurities at a concentration in the range of 1 × 10¹⁴ to 1 × 10¹⁵ atoms/cm³. As the n-type impurities, in addition to phosphorus (P), use can be made of nitrogen (N), arsenic (As), antimony (Sb), and bismuth (Bi), for example. The doping concentration of the n-type impurities is adjusted to fall in the range of 1 × 10¹⁴ to 1 × 10¹⁸ atoms/cm³.

Next, a diffusion preventive film S made of silicon oxide (SiO₂) is formed on the semiconductor substrate 2 by the thermal oxidation method.

A photoresist is applied onto the diffusion preventive film S, and the photoresist is exposed to light and developed by the photolithography method to obtain a desired pattern, whereafter an opening Sa for forming the p-type semiconductor region 32 is formed in the diffusion preventive film S by the wet etching method. The opening Sa does not necessarily have to be formed so as to pass through the diffusion preventive film S.

Then, a polyboron film (PBF) is applied onto the diffusion preventive film S. Subsequently, the p-type semiconductor region 32 is formed by causing boron (B) contained in the polyboron film (PBF) to diffuse into the semiconductor substrate 2 through the opening Sa of the diffusion preventive film S in accordance with the thermal diffusion method. At this time, for example, the polyboron film (PBF) has a thickness of 0.1 to 1 µm, and, thermal diffusion is effected in an atmosphere containing nitrogen (N2) and oxygen (02) and at a temperature in the range of 700 to 1200°C. After that, the diffusion preventive film S is removed.

Next, the semiconductor substrate 2 is subjected to heat treatment in a reactor of an MOCVD (Metal-organic Chemical vapor Deposition) apparatus to remove a natural oxide film formed on the surface of the semiconductor substrate 2. For example, the heat treatment is carried out for about 10 minutes at 1000°C.

Then, in accordance with the MOCVD method, the individual semiconductor layers (the buffer layer 30a, the n-type contact layer 30b, the n-type clad layer 30c, the active layer 30d, the p-type clad layer 30e, and the p-type contact layer 30f) constituting the light emitting element 3a are laminated one after another on the semiconductor substrate 2. Moreover, a photoresist is applied onto a stack of the semiconductor layers, and the photoresist is exposed to light and developed by the photolithography method to obtain a desired pattern, whereafter the light emitting element 3a is formed by the wet etching method. Note that etching is repeated several times to expose part of the upper surface of the n-type contact layer 30b. After that, the photoresist is removed.

Next, the insulating layer 8 is formed so as to cover the exposed surface of the light emitting element 3a and the upper surface of the semiconductor substrate 2 (including the p-type semiconductor region 32) by using the thermal oxidation method, the sputtering method, the plasma CVD method, or otherwise. Subsequently, a photoresist is applied onto the insulating layer 8, and the photoresist is exposed to light and developed by the photolithography method to obtain a desired pattern, whereafter openings for connecting the second electrode 31a, the third electrode 31b, and the fourth electrode 33b, which will hereafter be described, to the n-type contact layer 30b, the p-type contact layer 30f, and the p-type semiconductor region 32, respectively, are formed in the insulating layer 8 by the wet etching method. After that, the photoresist is removed.

Next, a region of the semiconductor substrate 2 on which the first electrode pad 33A, the first electrode 33a, and the guard ring electrode 34 are disposed is doped with phosphorus (P) by the thermal diffusion method and the ion implantation method.

Next, a photoresist is applied onto the insulating layer 8, and the photoresist is exposed to light and developed by the photolithography method to obtain a desired pattern, whereafter alloy films for constituting the second electrode 31a, the second electrode pad 31A, the fourth electrode 33b, the fourth electrode pad 33B, the first electrode 33a, and the first electrode pad 33A are formed by the resistance heating method, the sputtering method, or otherwise. Then, with use of the lift-off method, the photoresist is removed, and, the second electrode 31a, the second electrode pad 31A, the fourth electrode 33b, the fourth electrode pad 33B, the first electrode 33a, the first electrode pad 33A, and the guard ring electrode 34 are each shaped into a desired form. Also, the third electrode 31b and the light emitting element-side second electrode pad 33B are formed by a similar procedure.

Next, an alloy film for constituting the back electrode 34 is formed on the back side of the semiconductor substrate 2 by the resistance heating method, the sputtering method, or otherwise. The back electrode 34 of the present embodiment is formed throughout the entire back side of the semiconductor substrate 2.

### (Sensor device)

Next, a sensor device 100 including the light receiving/emitting element 1 will be described. The following description deals with a case where the light receiving/emitting element 1 is applied to a sensor device for detecting the position of a toner T (to-be-irradiated object) which has adhered onto an intermediate transfer belt V in an image forming apparatus such as a copying machine or a printer.

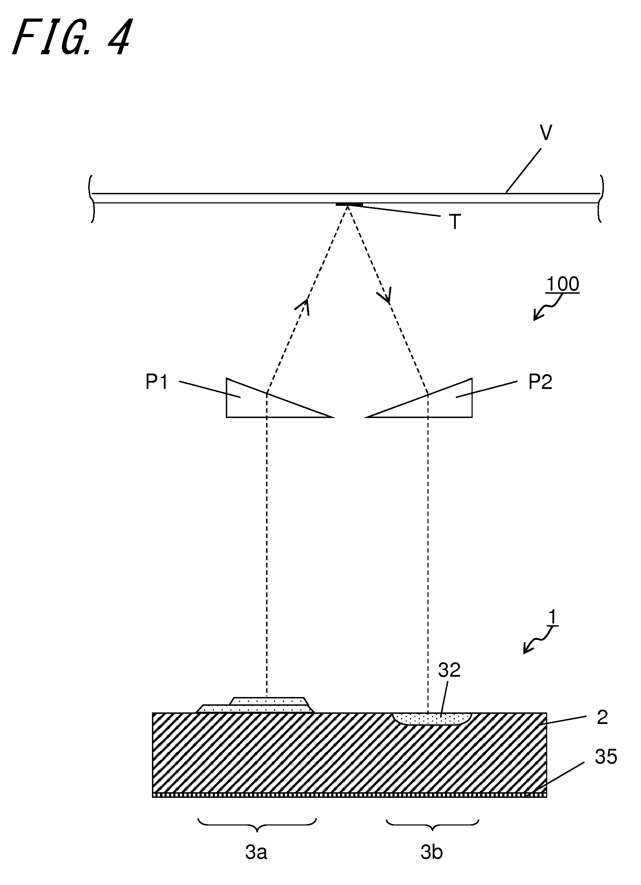

As shown in FIG. 4, the sensor device 100 according to the present embodiment is disposed so that a side of the light receiving/emitting element 1 on which the light emitting element 3a and the light receiving element 3b are formed is opposed to the intermediate transfer belt V. Light from the light emitting element 3a is applied to the intermediate transfer belt V or the toner T borne on the intermediate transfer belt V. In the present embodiment, a prism P1 is disposed above the light emitting element 3a, and a prism P2 is disposed above the light receiving element 3b. Light emitted from the light emitting element 3a is refracted by the prism P1 so as to enter the intermediate transfer belt V or the toner T borne on the intermediate transfer belt V. Regularly reflected light L2 with respect to the incident light L1 is refracted by the prism P2 so as to be received by the light receiving element 3b. A photoelectric current corresponding to the intensity of the received light is generated in the light receiving element 3b, and the photoelectric current is then detected by an external apparatus via the fourth electrode pad 33B, for example.

As described above, the sensor device 100 according to the present embodiment is capable of detecting a photoelectric current corresponding to the intensity of regularly reflected light from the intermediate transfer belt V or the toner T. Accordingly, for example, based on a photoelectric current value detected by the light receiving element 3b, detection as to whether the toner T is located in a predetermined position can be achieved. That is, the position of the toner T can be detected. Since the intensity of regularly reflected light corresponds to the concentration of the toner T, it is also possible to detect the concentration of the toner T based on the magnitude of generated photoelectric current. Similarly, since the intensity of regularly reflected light also corresponds to a distance from the light receiving/emitting element 1 to the toner T, it is also possible to detect the distance between the light receiving/emitting element 1 and the toner T based on the magnitude of generated photoelectric current.

The sensor device 100 according to the present embodiment affords the aforestated advantageous effects brought about by the light receiving/emitting element 1.

While particular embodiments of the invention have been shown and described, the application of the invention is not limited to this, and various changes and modifications are possible without departing from the scope of the invention.

For example, while, in the present embodiment, phosphorus (P) is adopted as the n-type impurities for the regions of the semiconductor substrate 2 located immediately below the first electrode pad 33A, the first electrode 33a, and the guard ring electrode 34, use can be made of arsenic (As) which is at least one of the elements constituting the buffer layer 30a formed as a semiconductor layer in contact with the upper surface of the semiconductor substrate 2. In this construction, there is no need to diffuse impurities into the regions located immediately below the first electrode pad 33A, the first electrode 33a, and the guard ring electrode 34 by the thermal diffusion method and the ion implantation method, thus achieving reduction of procedural steps, with consequent even shorter manufacturing process and reduction in manufacturing cost.

Arsenic (As) constituting the buffer layer 30a formed on the upper surface of the semiconductor substrate 2 diffuses into the semiconductor substrate 2 in the course of formation of the light emitting element 3a. In an etching process subsequent to the formation of the light emitting element 3a, semiconductor layers formed on regions other than the region formed with the light emitting element 3a are removed by etching, but a layer containing diffused arsenic (As) still remains at the upper surface of the semiconductor substrate 2. Although, under normal circumstances, this diffusion layer is removed by performing etching on the surface of the semiconductor substrate 2, at this time, an etching mask is formed in regions corresponding to the first electrode pad 33A, the first electrode 33a, and the guard ring electrode 34, respectively, by the photolithography method to avoid etching of the diffusion layer. Then, after removing the etching masks, the first electrode pad 33A, the first electrode 33a, and the guard ring electrode 34 are formed in the corresponding regions. Consequently, there exist n-type impurities, namely arsenic (As) in the regions located immediately below the first electrode pad 33A, the first electrode 33a, and the guard ring electrode 34.

Moreover, the first electrode pad 33A and the first electrode 33a, as well as the second electrode pad 31A and the second electrode 31a, may be made of the same material. While, in the present embodiment, the first electrode pad 33A and the first electrode 33a are made of a gold (Au)-germanium (Ge) alloy, whereas the second electrode pad 31A and the second electrode 31a are made of a gold (Au)-antimony (Sb) alloy, all of the first electrode pad 33A, the first electrode 33a, the second electrode pad 31A, and the second electrode 31a may be made of, for example, the gold (Au)-germanium (Ge) alloy. In this construction, electrode pad/electrode forming steps can be reduced, with consequent even shorter manufacturing process and reduction in manufacturing cost.

Moreover, although the sensor device 100 according to the present embodiment has been illustrated as being used to detect the concentration of the toner T, the application of the sensor device 100 is not limited to toner concentration detection. The sensor device 100 is capable of measurement of the surface conditions of a substance, and, for example, the sensor device 100 is capable of measurement of the surface conditions of human's bare skin or a tablet.

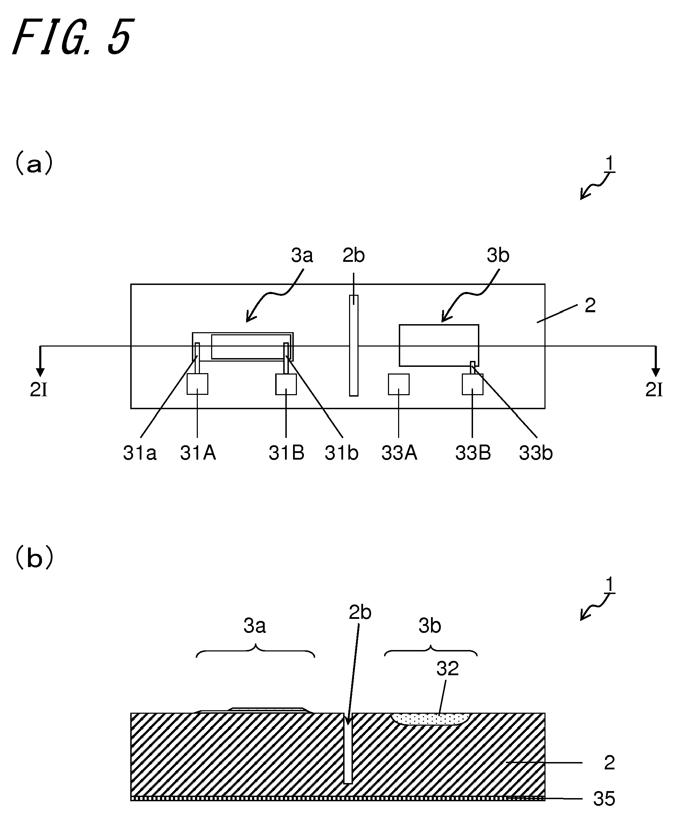

Moreover, as shown in FIG. 5, a groove 2b may be formed between the first electrode pad 33A and the light emitting element 3a on the semiconductor substrate 2. Consequently, noise current from the light emitting element 3a bypasses the groove 2b when flowing through the interior of the semiconductor substrate 2, and thereby it is possible to minimize the influence of the noise current upon the light receiving element 3b.

Moreover, the groove 2b located between the first electrode pad 33A and the light emitting element 3a may be formed so as to extend across one end and the other end of the semiconductor substrate 2. Consequently, this makes it possible to cause noise current from the light emitting element 3a to bypass the groove 2b satisfactorily.

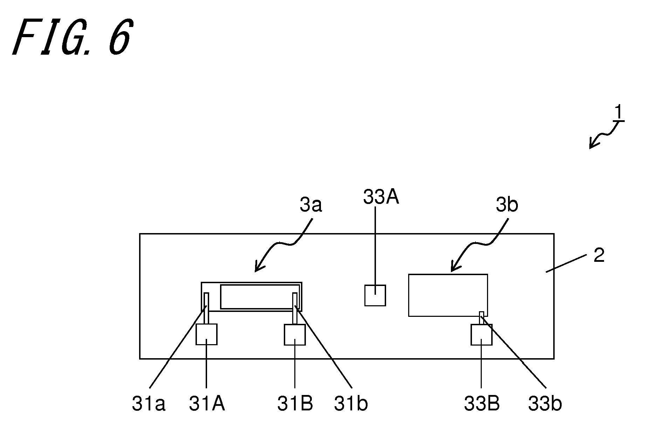

Moreover, as shown in FIG. 6, the first electrode pad 33A may be located in a region between the light emitting element 3a and the light receiving element 3b on the semiconductor substrate 2. Since such a construction is provided, in taking electric current out from the light receiving element 3b, upon application of a reverse bias to the first electrode pad 33A and the fourth electrode pad 33B, an electric field can be produced at a location immediately below the first electrode pad 33A. Consequently, when noise current from the light emitting element 3a flows through the interior of the semiconductor substrate 2, the noise current flows so as to bypass the electric field produced at the location immediately below the first electrode pad 33A. Accordingly, this makes it possible to reduce the influence of noise current from the light emitting element 3a upon the light receiving element 3b.

## Claims

1. A light receiving/emitting element comprising:
a semiconductor substrate having one conductivity type;
a light emitting element comprising a plurality of semiconductor layers disposed on an upper surface of the semiconductor substrate;
a light receiving element having a reverse conductivity type semiconductor region in the upper surface of the semiconductor substrate; and
a first electrode pad disposed on the upper surface of the semiconductor substrate, the first electrode pad being as an electrode of the light receiving element,
a region located immediately below the first electrode pad in the semiconductor substrate having one conductivity type being higher in impurity concentration than other regions in the semiconductor substrate having one conductivity type.

2. The light receiving/emitting element according to claim 1,
wherein impurities in the region located immediately below the first electrode pad comprise a same as at least one of elements constituting the semiconductor layer in contact with the upper surface of the semiconductor substrate.

3. The light receiving/emitting element according to claim 1 or 2,
wherein the plurality of semiconductor layers comprise a contact layer having one conductivity type,
the light receiving/emitting element further comprising: a second electrode disposed on an upper surface of the contact layer, the second electrode being as an electrode of the light emitting element,
the second electrode and the first electrode pad comprising a same material.

4. The light receiving/emitting element according to any one of claims 1 to 3,
wherein the region of the semiconductor substrate located immediately below the first electrode pad has a projection protruding toward the first electrode pad.

5. The light receiving/emitting element according to claim 4,
wherein the first electrode pad covers the projection.

6. The light receiving/emitting element according to any one of claims 1 to 5,
wherein the first electrode pad is located in a region between the light emitting element and the light receiving element.

7. The light receiving/emitting element according to any one of claims 1 to 6,
wherein the semiconductor substrate further comprises a groove located between the first electrode pad and the light emitting element.

8. A sensor device comprising:
the light receiving/emitting element according to any one of claims 1 to 7,
the light emitting element applying light to a to-be-irradiated object,
the light receiving element outputting an output current corresponding to reflected light from the to-be-irradiated object,
the sensor device being configured to detect at least one of positional information, distance information, and concentration information on the to-be-irradiated object based on the output current.
